# EUROPEAN PATENT SPECIFICATION

(11) **EP 0 986 015 B1**
(45) Date of publication and mention of the grant of the patent: **26.11.2003**
(21) Application number: 98830526.4
(22) Date of filing: 09.09.1998
(51) Int. Cl.: G06F 17/50

(54) **Method for the electric dynamic simulation of VLSI circuits**
Verfahren zur Dynamischen Elektrischen Simulation von VLSI Schaltungen
Procédé pour la simulation dynamique electrique des circuits VLSI

(43) Date of publication of application: 15.03.2000
(73) Proprietor: STMicroelectronics S.r.l., 20041 Agrate Brianza (Milano) (IT)
(72) Inventor: Chinosi, Mauro, 20041 Agrate Brianza (Prov. of Milan) (IT); Guardiani Carlo, 20050 Mezzago (Prov. of Milan) (IT)
(74) Representative: Modiano, Guido, Dr.-Ing.

(56) References cited:
- EP-A- 0 481 117
- DRAGONE N ET AL: "Power invariant vector compaction based on bit clustering and temporal partitioning" PROCEEDINGS. 1998 INTERNATIONAL SYMPOSIUM ON LOW POWER ELECTRONICS AND DESIGN (IEEE CAT. NO.98TH8379), PROCEEDINGS OF INTERNATIONAL SYMPOSIUM ON LOW POWER ELECTRONICS AND DESIGN, MONTEREY, CA, USA, 10-12 AUG. 1998, pages 118-120, XP002094403 ISBN 1-58113-059-7, 1998, New York, NY, USA, ACM, USA
- FROHLICH N ET AL: "A new approach for parallel simulation of VLSI circuits on a transistor level" IEEE TRANSACTIONS ON CIRCUITS AND SYSTEMS I: FUNDAMENTAL THEORY AND APPLICATIONS, JUNE 1998, IEEE, USA, vol. 45, no. 6, pages 601-613, XP002094404 ISSN 1057-7122

## Description

The present invention relates to a method for the electric dynamic simulation of VLSI circuits.

It is known that a VLSI circuit cannot be considered to be purely digital because of the presence of analog functions, customized blocks, memories etcetera. If a highly accurate simulation is required in order to check timings, power levels etcetera, an electric simulator should be used.

However, since electric simulators require a very long execution time and can be applied only to relatively small circuits, it is necessary to use alternative methods for simulation.

On the one hand, digital simulators, which are an alternative to electric simulators, are fast, can handle large circuits and provide good modeling capabilities, but they cannot take into account any analog behavior of the circuit.

on the other hand, electric simulators are slow, highly accurate, take any signal into account, but cannot handle large and complex circuits because of their low speed.

It is known that a simulation is a simplified representation of reality. An electric circuit is modeled by means of elements which describe its function. The more accurate the descriptions provided, the closer the results are to reality.

In circuits of the VLSI (Very Large Scale Integration) type, a circuit can be composed of devices and connections which represent the component used by designers (MOS, capacitors, etcetera) and of millions of "parasitic" components correlated to the physical implementation of the circuit on the silicon wafer.

These devices are stimulated by a testing rig which represents the action of the outside world on the circuit.

For any device, a group of equations (model) is solved in order to calculate (predict) responses of the circuit to the stimuli generated by the testing rig.

Since these equations might be very complex and must be solved in short times, this can entail an insolvable problem owing to the unreliability of the CPU in terms of processing speed.

Frohlich et al: "A new approach for parallel simulation of VLSI circuits on a transistor level" IEEE TRANSACTIONS ON CIRCUITS AND SYSTEMS I: FUNDAMENTAL THEORY AND APPLICATIONS, JUNE 1988, IEEE, USA, vol. 45, no. 6, pages 601-613, XP002094404 ISSN 1057-7122 discloses several approaches that divide the circuit to be simulated into smaller subcircuits.

The aim of the present invention is therefore to provide a method for the electric dynamic simulation of VLSI circuits which allows to combine the advantages of an electric simulator with those of a digital simulator.

Within the scope of this aim, an object of the present invention is to provide a method for the electric dynamic simulation of VLSI circuits which is capable of providing the results of the simulation in a short time.

Another object of the present invention is to provide a method for the electric dynamic simulation of VLSI circuits which operates in a parallel manner on various hardware devices.

Another object of the present invention is to provide a method for the electric dynamic simulation of VLSI circuits which allows to use a reduced amount of memory to record the results with respect to known methods.

Another object of the present invention is to provide a method for the electric dynamic simulation of VLSI circuits which allows to reduce the simulation load affecting the CPU.

Another object of the present invention is to provide a method for the electric dynamic simulation of VLSI circuits which is highly reliable, relatively easy to provide and at competitive costs.

This aim, these objects and others which will become apparent hereinafter are achieved by a method for the electric dynamic simulation of VLSI circuits, as defined in claim 1.

Further characteristics and advantages of the invention will become apparent from the description of a preferred embodiment of the method according to the invention, illustrated only by way of non-limitative example in the accompanying drawings, wherein:
Figure 1 is a view of an example of extraction of the active dynamic devices from an electronic circuit; and
Figure 2 is a table listing the results obtained by applying the method according to the invention and a known method to a plurality of different circuits.

With reference to the above figures, the method according to the present invention starts by considering that in real applications not all devices are active at the same time. The larger the circuit, the higher the likelihood that there are inactive devices at a given moment.

The presence of "latency" is a key factor to be used in order to reduce the processing time of the CPU of the hardware device used for the simulation.

The circuit to be modeled is therefore considered as a dynamic combination of devices which are activated as a consequence of the propagation of the stimuli at the primary input of the chip. At any given instant, the "active" circuit is constituted by the group of devices excited by the stimuli or by the response of other devices excited earlier by said stimuli.

The remainder of the devices of the circuit that are not involved do not change state and might therefore be ignored, from the functional point of view, as regards modeling, as occurs in a differential analysis. In this manner it is possible to conveniently reduce the size of the circuit to be simulated and also provide parallelization.

Accordingly, the simulation must be:
-- limited exclusively to the devices whose state changes;
-- parallelized according to given criteria.

First of all, the method according to the invention provides for the extraction of the "active" devices, i.e., of the devices for which a digital transition is detected.

As mentioned, if a device is digitally inactive and does not influence other devices, it could be removed from the list of active devices, since its nodes do not change their value (state).

The result does not change if the value of said nodes is assigned to the driven devices and if an appropriate capacitive load replaces the device and is connected to the device that sends the driving signals.

A device is defined as a group of primitive elements (MOS, capacitors, etcetera) enclosed in a block whose input/output gates are known.

A device is also considered active if a "digital" transition is detected at any one of its gates.

By reference to the above definitions, it is clear that a known digital simulator can detect changes of any order of a circuit and can also digitally log the value of all the nodes. By means of an interface it can be possible to access the internal database of the digital simulator and extract any type of information related to the nodes.

Accordingly, the circuit is reduced to a plurality of subcircuits or subnetworks in which the devices are included if at least one of their gates is connected to another device whose value has changed.

All the gates are then processed and:
-- connected to the network, if it is a simulated network;
-- connected to the ground or to the supply voltage, if there are no simulated inputs;
-- connected to the corresponding network and initialized if there are no simulated inputs or outputs.

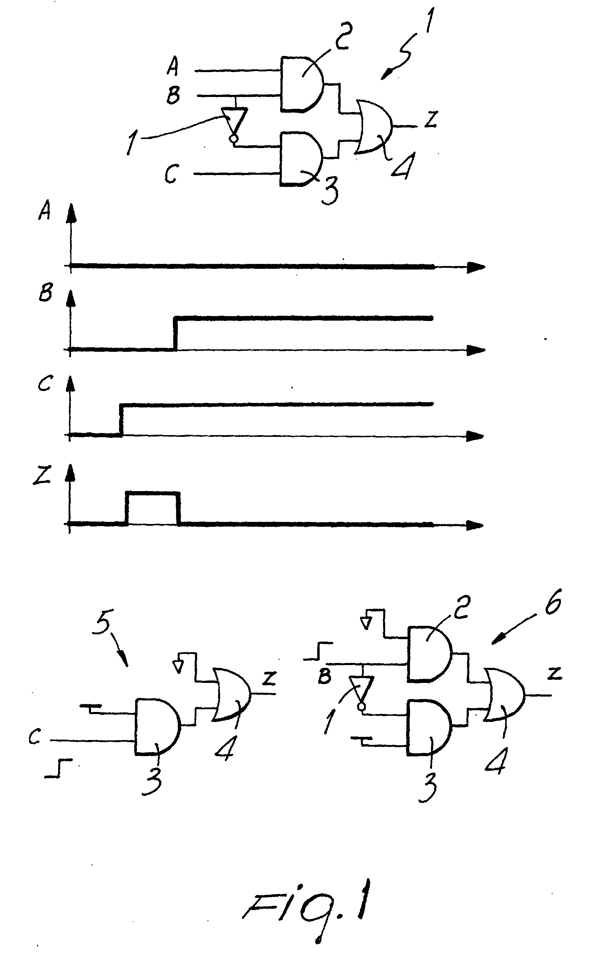

The generated subnetworks are a subset of the entire set of devices of the circuit and are composed of the devices that are connected to simulated networks in a given time interval. An example of an initial complete circuit and of its subnetworks for a simple simulation is given in Figure 1, in which the reference numeral 1 designates the initial circuit to be simulated, with inputs A, B, C and an output Z.

The example circuit is composed of a set of logic gates, and specifically a NOT gate 1, two AND gates 2 and 3, and an OR gate 4.

The signals A, B, C and Z are shown in the charts of Figure 1 and yield the subnetworks, designated by the reference numerals 5 and 6, which represent the active devices according to the instant considered in relation to the application of the signals A, B and C.

The subnetwork 5 is a schematic representation of the circuit 1 at the instant in which the signals A and B are nil and the signal C has a step.

In this case, the NOT gate 1 is not present, since its input is nil, while the second input of the AND gate 3, in addition to the input C, is connected to the supply voltage, since a high signal would have been output by the NOT gate 1 with a low signal B as input.

Viceversa, the input of the OR gate 4 that is the output of the AND gate 2 is connected to the ground, since a low output signal would be present on the AND gate 2.

The second subnetwork, designated by the reference numeral 6, is the circuit obtained when the signal B performs a transition from low to high while the signal C is still high.

In this case, therefore, the NOT gate 1 is included in the subcircuit, while the input of the AND gate 3 that corresponds to the signal C is at the supply voltage, since said signal does not perform a transition but remains high, as in the situation occurring in the circuit 5.

Therefore, on the basis of the timing chart of the signals A, B and C, the circuit 1 is divided into the two subcircuits 5 and 6, which include only the devices that are active at that given instant.

The following information and other data can be processed:
-- finding all simulated subcircuits;
-- finding all subcircuits connected to a module;
-- finding the state (node value) of a subcircuit.

A combination of the above information leads to the extraction of the devices that are active at every instant according to the different timings of the signals.

It is also possible to determine the state of subcircuits that are not simulated.

In general, the devices are included in the subcircuit that must be simulated electrically if at least one of their gates is connected to a subcircuit whose value has changed.

The dynamic time-dependent partitioning of the circuit is provided according to different methods: a fixed time interval or a time interval defined between the time elapsed between transitions of signals arriving from the testing rig and input to the circuit, or for example the ratio between active devices and all devices is considered.

The advantage of using the signal or signals arriving from the testing rig is given by the fact that the slope of said signal is known and therefore a time interval considered to extract the active devices and thus form subcircuits composed exclusively of the active circuits, starting from the circuit to be simulated, occurs at an input transition of said signal.

Therefore, whenever a subcircuit composed of a plurality of active devices is extracted, it is possible to perform an independent simulation for each subcircuit and it is therefore possible to perform them in parallel on different hardware devices. Clearly, the results are valid only as regards the time interval to which the "current" subcircuit relates.

Although the active devices change dynamically from one time interval to the next, the state of the input/output ports of the devices is known by virtue of the digital simulator. This allows compatibility of the internal state even if one or more input nodes of the current device are not connected to any driving device.

If the device has an internal node which maintains a memory-type behavior, such as for example a flip-flop, the nodes must become visible outside the device. For example, they might be handled as extended floating outputs (i.e., with non-connected output pin). All the output nodes, including the latter, can furthermore be initialized, obtaining a faster convergence for the DC operating point. The internal nodes are resolved automatically by the simulator during the evaluation of the DC operating point. Floating nodes cannot be accessed by the digital simulator. The electric simulator provides a hypothesis on the basis of its internal heuristics.

As regards data collection, the individual results can be concatenated together in order to compose the entire simulation.

Simulation then entails extracting the active devices, i.e., the devices for which a digital transition has been detected, a step for evaluating the voltage that is present on the inactive nodes of the circuit and an estimate of the equivalent loads for replacing said nodes.

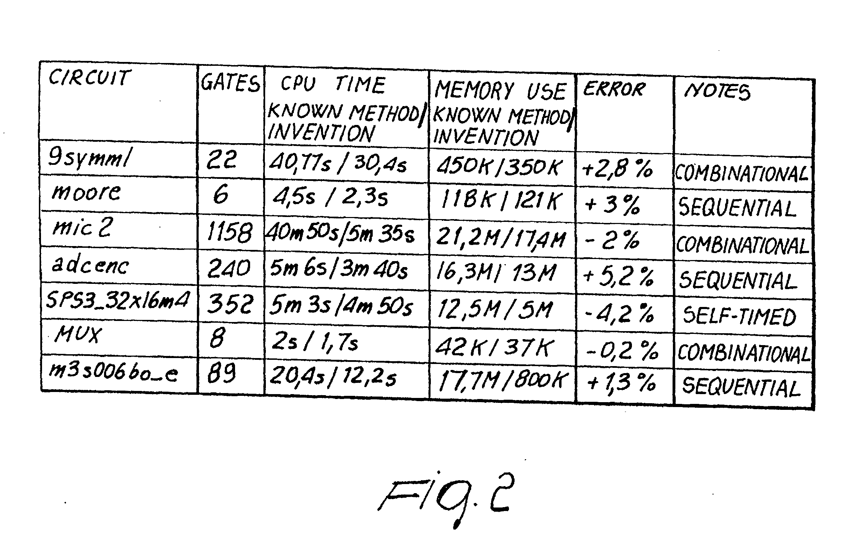

Figure 2 is a table which compares various circuits listed in the first column of the table, constituted by the number of gates listed in the second column, while a third column indicates the operating time of the CPU, comparing the simulation of the full circuit and the simulation performed by means of the method according to the invention.

The fourth column of the table lists the memory occupation of modeling performed by means of known methods in comparison with modeling performed by means of the method according to the invention.

The fifth column lists a percentage error for the calculated average power level of the simulated circuit and the last column lists the type of circuit, which can be combinational, sequential or self-timed.

In practice it has been observed that the method according to the invention fully achieves the intended aim and objects, since it allows to split the simulation of a large circuit into a plurality of simulations of smaller independent subcircuits, each of which can be simulated electrically. In this manner, the electrical simulation is faster and can also be performed in parallel, since each circuit is independent of the other.

The method thus conceived is susceptible of numerous modifications and variations, all of which are within the scope of the invention as defined by the claims; all the details may furthermore be replaced with other technically equivalent elements.

## Claims

1. A method for the electric dynamic simulation of VLSI circuits, comprising the steps of automatically:
-- determining, by means of a digital simulator and starting from a circuit to be simulated, a plurality of independent subcircuits whose dimensions are equal to, or smaller than, those of said circuit;
-- electrically simulating each one of said subcircuits;
-- concatenating the results obtained by means of said electric simulations of the subcircuits;
said step of determining a plurality of independent subcircuits comprising the steps of:
-- defining a time interval;
-- extracting, for each time interval, devices of said circuit for which a digital transition is detected;
-- evaluating the voltage that is present on inactive nodes of said circuit;
-- estimating equivalent loads for replacing said inactive nodes.

2. The method according to claim 1, **characterized in that** said step of using a digital simulator entails the use of said digital simulator together with an interface.

3. The method according to claim 1, **characterized in that** said step of electrically simulating each one of said subcircuits is performed by means of an electric simulator.

4. The method according to claim 1, **characterized in that** said devices for which a digital transition is detected are active devices, said digital transition occurring if at least one of the gates of the device is connected to a node of the circuit that has changed value.

5. The method according to one or more of the preceding claims, **characterized in that** each input of an active device of the circuit is connected to the supply voltage if
**in that** given time interval the signal that is normally present at said input is high and is connected to the ground if the signal that is normally present at said input is low.

6. The method according to one or more of claims 1-5, **characterized in that** said time interval is determined as the time elapsed between two transitions of input signals arriving from a testing rig.

7. The method according to one or more of claims 1-5, **characterized in that** said time interval is determined as a fixed time.

8. The method according to one or more of claims 1-5, **characterized in that** said time interval is determined by the ratio between active devices and total devices.

9. The method according to one or more of claims 1-5, **characterized in that** said time interval is determined on the basis of statistics obtained from other preceding simulations.

## Patentansprüche

1. Verfahren zur dynamischen elektrischen Simulation von VLSI-Schaltungen, welches folgende automatische Schritte umfasst:
- Bestimmen, mittels eines digitalen Simulators und ausgehend von einer zu simulierenden Schaltung, einer Mehrzahl von unabhängigen Teilschaltungen, deren Dimensionen kleiner oder gleich denen der Schaltung sind;
- elektrisches Simulieren von jeder dieser Teilschaltungen;
- Verknüpfen der Resultate, die mittels der elektrischen Simulationen der Teilschaltungen erhalten worden sind;
wobei der Schritt des Bestimmens einer Mehrzahl von unabhängigen Teilschaltungen folgende Schritte aufweist:
- Definieren eines Zeitintervalls;
- Extrahieren von Einrichtungen von der Schaltung, für welche ein digitaler Übergang detektiert worden ist, für jedes Zeitintervall;
- Evaluieren der Spannung, die an den inaktiven Knoten der Schaltung anliegt;
- Schätzen von äquivalenten Ladungen zum Ersetzen der inaktiven Knoten.

2. Verfahren nach Anspruch 1, **dadurch gekennzeichnet, dass** der Schritt des Verwendens eines digitalen Simulators die Verwendung des digitalen Simulators zusammen mit einer Schnittstelle mit sich bringt.

3. Verfahren nach Anspruch 1, **dadurch gekennzeichnet, dass** der Schritt des elektrischen Simulierens von jeder der Teilschaltungen mittels eines elektrischen Simulators durchgeführt wird.

4. Verfahren nach Anspruch 1, **dadurch gekennzeichnet, dass** die Einrichtungen, für welche ein digitaler Übergang detektiert worden ist, aktive Einrichtungen sind, wobei der digitale Übergang auftritt, falls wenigstens eines der Gatter der Einrichtung mit einem Knoten der Schaltung verbunden ist, der seinen Wert geändert hat.

5. Verfahren nach einem oder mehreren der vorhergehenden Ansprüche, **dadurch gekennzeichnet, dass** jeder Eingang einer aktiven Einrichtung der Schaltung mit der Versorgungsspannung verbunden ist, falls in dem gegebenen Zeitintervall das Signal, das üblicherweise an dem Eingang anliegt, auf hohem Niveau liegt und mit Masse verbunden ist, falls das Signal, das üblicherweise am Eingang anliegt, auf niedrigem Niveau liegt.

6. Verfahren nach einem oder mehreren der Ansprüche 1 bis 5, **dadurch gekennzeichnet, dass** das Zeitintervall als die Zeit bestimmt wird, die zwischen zwei Übergängen der von einer Testanlage eintreffenden Eingangssignale verstrichen ist.

7. Verfahren nach einem oder mehreren der Ansprüche 1 bis 5, **dadurch gekennzeichnet, dass** das Zeitintervall als eine fest Zeit bestimmt wird.

8. Verfahren nach einem oder mehreren der Ansprüche 1 bis 5, **dadurch gekennzeichnet, dass** das Zeitintervall durch das Verhältnis zwischen aktiven Einrichtungen und allen Einrichtungen bestimmt wird.

9. Verfahren nach einem oder mehreren der Ansprüche 1 bis 5, **dadurch gekennzeichnet, dass** das Zeitintervall auf der Basis von Statistiken bestimmt wird, die von der anderen vorhergehenden Simulationen erhalten worden sind.

## Revendications

1. Procédé de simulation électrique dynamique de circuits à haute intégration (VLSI), comprenant les étapes suivantes, réalisées de façon automatique :
- déterminer au moyen d'un simulateur numérique et en commençant à partir d'un circuit simulé, une pluralité de sous-circuits indépendants dont les dimensions sont égales ou inférieures à celles dudit circuit ;
- simuler électriquement chacun des sous-circuits ;
- rassembler les résultats obtenus par lesdites simulations électriques des sous-circuits ;
l'étape de détermination d'une pluralité de sous-circuits indépendants comprenant les étapes suivantes :
- définir un intervalle de temps ;
- extraire pour chaque intervalle de temps des dispositifs du circuit pour lesquels une transition numérique est détectée ;
- évaluer la tension présente sur des noeuds inactifs du circuit ; et
- estimer les charges équivalentes pour remplacer les noeuds inactifs.

2. Procédé selon la revendication 1, **caractérisé en ce que** l'étape d'utilisation d'un simulateur numérique implique l'utilisation du simulateur numérique avec une interface.

3. Procédé selon la revendication 1, **caractérisé en ce que** l'étape de simulation électrique de chacun des sous-circuits est réalisée par un simulateur électrique.

4. Procédé selon la revendication 1, **caractérisé en ce que** les dispositifs pour lesquels une transition numérique est détectée sont des dispositifs actifs, La transition numérique survenant si au moins une des portes du dispositif est connectée à un noeud du circuit qui a changé de valeur.

5. Procédé selon une ou plusieurs des revendications précédentes, **caractérisé en ce que** chaque entrée d'un dispositif actif du circuit est connectée à la tension d'alimentation si, dans cet intervalle de temps donné, le signal qui est normalement présent sur ladite entrée est haut, et est connectée à la masse si le signal qui est normalement présent sur ladite entrée est bas.

6. Procédé selon une ou plusieurs des revendications 1 à 5, **caractérisé en ce que** ledit intervalle de temps est déterminé comme étant ledit temps écoulé entre deux transitions de signaux d'entrée provenant d'un équipement de test.

7. Procédé selon une ou plusieurs des revendications 1 à 5, **caractérisé en ce que** ledit intervalle de temps est déterminé à un instant fixe.

8. Procédé selon une ou plusieurs des revendications 1 à 5, **caractérisé en ce que** ledit intervalle de temps est déterminé par le rapport entre les dispositifs actifs et l'ensemble des dispositifs.

9. Procédé selon une ou plusieurs des revendications 1 à 5, **caractérisé en ce que** ledit intervalle de temps est déterminé sur la base de statistiques obtenues à partir d'autres simulations précédentes.
